# EUROPEAN PATENT APPLICATION

(11) **EP 4 604 694 A1**
(43) Date of publication of application: **20.08.2025**
(21) Application number: 24213606.7
(22) Date of filing: 18.11.2024
(51) Int. Cl.: H10D 89/60

(54) **SEMICONDUCTOR DEVICE**

(30) Priority: 13.02.2024 KR 20240020409; 17.04.2024 KR 20240051284
(71) Applicant: Samsung Electronics Co., Ltd., Suwon-si, Gyeonggi-do 16677 (KR)
(72) Inventor: SONG, Jongkyu, 16677 Suwon-si, Gyeonggi-do (KR); HEO, Jin, 16677 Suwon-si, Gyeonggi-do (KR); KIM, Minho, 16677 Suwon-si, Gyeonggi-do (KR); KIM, Sukjin, 16677 Suwon-si, Gyeonggi-do (KR); JUNG, Jinwoo, 16677 Suwon-si, Gyeonggi-do (KR)
(74) Representative: Kuhnen & Wacker Patent- und Rechtsanwaltsbüro PartG mbB

(57) **Abstract**

A semiconductor device includes a first well region (405) in a substrate and doped with impurities of a first conductivity type, a second well region (406) in the substrate and doped with impurities of a second conductivity type, where the second well region (406) is on internal sides of the first well region (405) in a first direction that is parallel to an upper surface of the substrate, a first impurity region (408) in the first well region (405) and doped with impurities of the first conductivity type, a plurality of active regions (411, 412) in the second well region (406) along the first direction and doped with impurities of the first conductivity type, a gate structure (413) between the plurality of active regions (411, 412) in the first direction, a first dummy gate structure (420) on the first impurity region (408) and at least partially surrounding the second well region (406), and a plurality of wiring patterns (440), wherein the first dummy gate structure (420) is connected to the gate structure (413) by at least one of the plurality of wiring patterns (440).

## Description

### BACKGROUND

Example embodiments of the disclosure relate to a semiconductor device.

A semiconductor device may include a plurality of semiconductor devices, and a portion of the plurality of semiconductor devices may include a receiver circuit and a transmitter circuit for exchanging signals with other external semiconductor devices. A receiver circuit and a transmitter circuit may be connected to pads that are externally exposed, to transmit and receive signals, and a portion of the pads may be provided as a power pad for receiving a power voltage. To protect a semiconductor device from electrostatic discharge (ESD) entering the pads from an external region of the semiconductor device, a portion of the pads may be connected to an ESD protective circuit. It may be necessary to implement an ESD protective circuit to effectively protect a semiconductor device, and also, it may be necessary to reduce an area occupied by an ESD protective circuit to improve integration density of the semiconductor device.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a semiconductor device with improved integration density by implementing a capacitor included in an electrostatic discharge (ESD) protective circuit as a dummy gate structure.

Additional aspects will be set forth in part in the description which follows and, in part, will be apparent from the description, or may be learned by practice of the presented embodiments.

According to an aspect of one or more embodiments, a semiconductor device may include a first well region in a substrate and doped with impurities of a first conductivity type, a second well region in the substrate and doped with impurities of a second conductivity type, where the second well region is on internal sides of the first well region in a first direction that is parallel to an upper surface of the substrate (e.g. the first well region may surround the second well region in a top view), a first impurity region in the first well region and doped with impurities of the first conductivity type, a plurality of active regions in the second well region along the first direction and doped with impurities of the first conductivity type, a gate structure between the plurality of active regions in the first direction, a first dummy gate structure on the first impurity region and at least partially surrounding the second well region, and a plurality of wiring patterns, where the first dummy gate structure is connected to the gate structure by at least one wiring pattern of the plurality of wiring patterns.

According to an aspect of one or more embodiments, a semiconductor device may include a plurality of impurity regions in a substrate, a first active region and a second active region arranged in a first direction parallel to an upper surface of the substrate, a gate structure between the first active region and the second active region in the first direction, a first dummy gate structure on at least one impurity region among the plurality of impurity regions and connected to the gate structure, a plurality of wiring patterns including a first power wiring pattern configured to supply a first power voltage and a second power wiring pattern configured to supply a second power voltage different from the first power voltage, and a resistor element connected to the gate structure, where the first power wiring pattern is connected to the first active region and the second power wiring pattern is connected to the second active region.

According to an aspect of one or more embodiments, a semiconductor device may include a substrate, a first active region and a second active region in the substrate, an impurity region different from the first active region and the second active region, a gate structure on the substrate between the first active region and the second active region, where the first active region, the second active region and the gate structure are configured as a switch element together, and a dummy gate structure on at least one region among the first active region, the second active region, and the impurity region, where the dummy gate structure and the at least one region are configured as a capacitor and the capacitor is connected between the gate structure and one of the first active region and the second active region.

### BRIEF DESCRIPTION OF DRAWINGS

The above and other aspects, features, and advantages of certain example embodiments of the present disclosure will be more apparent from the following description taken in conjunction with the accompanying drawings, in which:
FIG. 1 is a diagram illustrating a semiconductor device according to one or more embodiments;
FIG. 2A is a circuit diagram illustrating a structure of an electrostatic discharge (ESD) protective circuit included in a semiconductor device according to a comparative example;
FIG. 2B is a circuit diagram illustrating a structure of an ESD protective circuit included in a semiconductor device according to one or more embodiments;
FIG. 3 is a graph illustrating an operation of an ESD protective circuit included in a semiconductor device according to one or more embodiments;
FIG. 4 is a diagram illustrating a layout of an ESD protective circuit according to one or more embodiments;
FIGS. 5 to 8 are diagrams illustrating an ESD protective circuit according to one or more embodiments;
FIGS. 9 to 11 are diagrams illustrating an ESD protective circuit according to one or more embodiments;
FIGS. 12 to 14 are diagrams illustrating an ESD protective circuit according to one or more embodiments;
FIGS. 15 to 17 are diagrams illustrating an ESD protective circuit according to one or more embodiments;
FIGS. 18 to 20 are diagrams illustrating an ESD protective circuit according to one or more embodiments;
FIGS. 21 to 23 are diagrams illustrating an ESD protective circuit according to one or more embodiments; and
FIGS. 24 to 26 are diagrams illustrating an ESD protective circuit according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

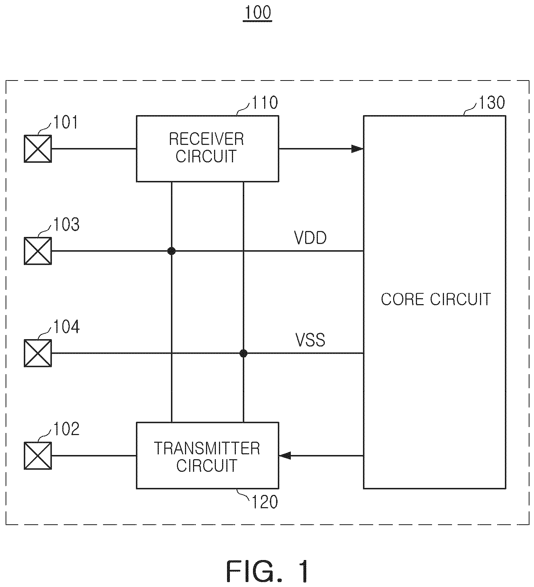

FIG. 1 is a diagram illustrating a semiconductor device according to one or more embodiments.

Referring to FIG. 1, a semiconductor device 100 according to one or more embodiments may include signal pads 101 and 102, power pads 103 and 104, a receiver circuit 110, a transmitter circuit 120, and a core circuit 130. The semiconductor device 100 may exchange signals with other external semiconductor devices through the signal pads 101 and 102.

The core circuit 130 may include a plurality of semiconductor devices. The semiconductor devices included in the core circuit 130 may include various circuits for the semiconductor device 100 to provide predetermined functions, such as a central processing unit (CPU), a graphics processing unit (GPU), an image signal processor (ISP), a neural processing unit (NPU), a modem, and a cache memory.

A power voltage VDD and a reference voltage VSS used for operation of the core circuit 130 may be input to the power pads 103 and 104. For example, the first power voltage VDD may be input to the first power pad 103, and the second power voltage VSS having a lower level than a level of the first power voltage VDD may be input to the second power pad 104.

A high voltage due to electrostatic discharge (ESD) may be applied to at least a portion of the pads 101-104 of the semiconductor device 100. For example, under ESD event conditions in which a high voltage is applied to at least one of the pads 101-104 due to ESD, a relatively large ESD current generated due to ESD may flow into the core circuit 130, such that a semiconductor element may be damaged. For example, an ESD event may occur in a circumstance in which a body is in close proximity to at least one of the floating pads 101-104.

To prevent damage to the semiconductor element occurring under ESD event conditions described above, the core circuit 130 may include an ESD protective circuit. The ESD protective circuit may be configured in various manners in example embodiments. For example, the ESD protective circuit may include a power clamp circuit connected between the first power pad 103 and the second power pad 104. Also, as an example, the ESD protective circuit may be connected to one of the signal pads 101 and 102 and may provide a discharge path for ESD current flowing into the signal pads 101 and 102.

The ESD protective circuit connected between the first power pad 103 and the second power pad 104 may include a switch element, capacitor, resistor element, or the like. The switch element may be implemented as an n-type metal-oxide-semiconductor (MOS) (NMOS) transistor or a p-type MOS (PMOS) transistor, and a gate of the switch element may be connected to a node between the resistor element and the capacitor. When ESD current flows into at least one of the pads 101-104, a gate voltage of the switch element may increase by resistor-capacitor (RC) trigger operation, and the ESD current may be discharged to the second power pad 104 through a current path provided by a channel of the switch element.

For the operation above, the ESD protective circuit may include a resistor element and a capacitor, and the capacitor may be implemented as a MOS capacitor provided separately from the switch element. However, when the capacitor is implemented as a MOS capacitor, an area occupied by the ESD protective circuit may increase due to the MOS capacitor, and integration density of the semiconductor device 100 may decrease.

In one or more embodiments, a dummy gate structure may be formed in an active region for implementing the switch element and/or the impurity region around the switch element, and the capacitor connected to the resistor element may be implemented as a dummy gate structure. Accordingly, the MOS capacitor formed in another region may not be provided, such that integration density of the semiconductor device 100 may be improved by reducing the area of the ESD protective circuit.

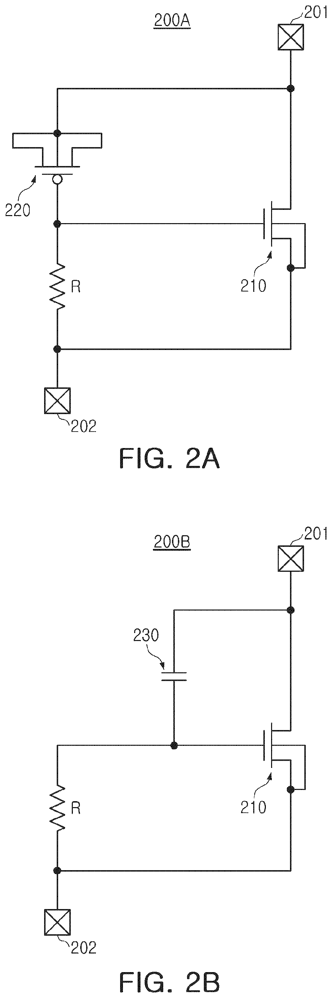

FIG. 2A is a circuit diagram illustrating a structure of an ESD protective circuit included in a semiconductor device according to a comparative example. FIG. 2B is a circuit diagram illustrating a structure of an ESD protective circuit included in a semiconductor device according to one or more embodiments.

Referring to FIG. 2A, the ESD protective circuit 200A may be connected to a first power pad 201 and a second power pad 202, and may include a switch element 210, a capacitor 220 and a resistor element R. As described above, the capacitor 220 of the ESD protective circuit 200A according to the comparative example may be implemented as a MOS capacitor and may be connected between a resistor element R and a first power pad 201.

A gate of the switch element 210 may be connected to a node between the resistor element R and the capacitor 220, a drain of the switch element 210 may be connected to the first power pad 201, and a source may be connected to the second power pad 202. However, when the switch element 210 is implemented as a PMOS transistor, a connection structure between the switch element 210 and the first power pad 201 and the second power pad 202 may be different.

When capacitor 220 is implemented using a MOS capacitor, which is an individual element as illustrated in FIG. 2A, an area occupied by an ESD protective circuit 200A may increase due to a region for forming the MOS capacitor. Generally, since a single semiconductor device may include two or more ESD protective circuits 200A, the area of the capacitor 220 implemented as a MOS capacitor may not be negligible.

In one or more embodiments, as illustrated in FIG. 2B, the capacitor 230 may be implemented by forming a dummy gate structure in an active region included in the switch element 210 and/or in another impurity region distinct from the active region of the switch element 210. Referring to FIG. 2B, the ESD protective circuit 200B according to one or more embodiments may also be connected to the first power pad 201 and the second power pad 202, and may include a resistor element R, a switch element 210, and a capacitor 230.

However, in contrast to the comparative example illustrated in FIG. 2A, the capacitor 230 may not be implemented as a MOS capacitor. By implementing the capacitor 230 by forming a dummy gate structure in the active region included in the switch element 210 and/or in another impurity region distinct from the active region of the switch element 210, the area occupied by the ESD protective circuit 200B may be reduced. For example, when the capacitor 230 is implemented as a dummy gate structure instead of a MOS capacitor, an area reduction of more than 20% may be obtained.

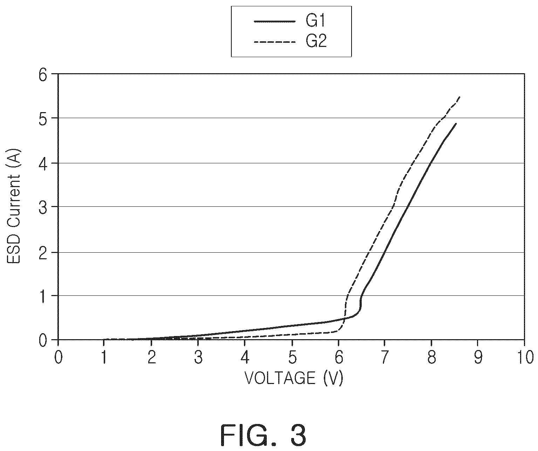

FIG. 3 is a graph illustrating an operation of an ESD protective circuit included in a semiconductor device according to one or more embodiments.

FIG. 3 illustrates a graph of ESD current generated due to an ESD event. The ESD current may be generated when a voltage applied to at least one of pads of a semiconductor device increases above a predetermined level due to an ESD event, and the voltage at which the ESD current increases rapidly may be defined as a trigger voltage.

When an ESD event occurs and a voltage of at least one of the pads increases above a trigger voltage, an RC trigger operation may be executed in the ESD protective circuit, such that a channel maybe formed in the switch element, and the ESD current may be discharged through the channel. As described above, the ESD current may be discharged through a pad receiving ground voltage.

In the graph illustrated in FIG. 3, the first line G1 may indicate the ESD current properties of the ESD protective circuit 200A according to the comparative example illustrated in FIG. 2A, and the second line G2 may indicate the ESD current properties of the ESD protective circuit 200B according to one or more embodiments illustrated in FIG. 2B. Referring to FIG. 3, a trigger voltage and a trigger current may be relatively low as shown by the second line G2 as compared to the first line G1, whereas a failure current may be higher. Accordingly, using capacitance provided by the dummy gate structure formed in the active region of the switch element and/or the impurity region different from the active region, performance almost similar to an ESD protective circuit including a MOS capacitor occupying a relatively large area may be implemented.

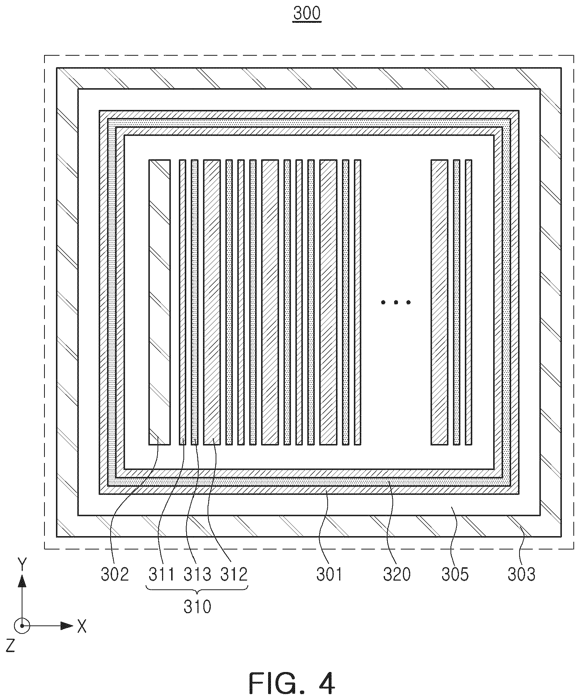

FIG. 4 is a diagram illustrating a layout of an ESD protective circuit according to one or more embodiments.

Referring to FIG. 4, an ESD protective circuit 300 according to one or more embodiments may include a plurality of impurity regions 301-303, a plurality of active regions 311 and 312, a plurality of gate structures 313, and a dummy gate structure 320. Each of the plurality of impurity regions 301-303 and the plurality of active regions 311 and 312 may be doped with impurities and may be isolated from each other by a device isolation film 305. The plurality of impurity regions 301-303, the plurality of active regions 311 and 312, the plurality of gate structures 313, and the dummy gate structure 320 may be electrically connected to each other by contacts and wiring patterns and may provide the ESD protective circuit 300.

Each of the plurality of gate structures 313 may be disposed between the first active region 311 and the second active region 312 in the first direction (e.g., X-axis direction). The gate structure 313 may provide a switch element 310 together with a first active region 311 and a second active region 312 disposed on both sides in the first direction. In one or more embodiments illustrated in FIG. 4, the plurality of first active regions 311 may be electrically connected to each other and may provide a source for the switch element 310, and the plurality of second active regions 312 may be electrically connected to each other and may provide a drain for the switch element 310. The plurality of gate structures 313 may be electrically connected to each other and may provide a gate for the switch element 310. In one or more embodiments illustrated in FIG. 4, a width of each of the plurality of second active regions 312 providing a drain may be larger than a width of each of the plurality of first active regions 311 providing a source.

The plurality of impurity regions 301-303 may include a first impurity region 301 doped with impurities of a first conductivity type, the second impurity region 302 disposed on an internal side of the first impurity region 301 in the first and second directions (e.g., Y-axis direction), and a third impurity region 303 disposed on an external side of the first impurity region 301 in the first and second directions.

In one or more embodiments, the switch element 310 may be formed in a well region having a twin-well structure. The well region of the twin-well structure may include a first well region doped with impurities of the first conductivity type, and a second well region doped with impurities of the second conductivity type different from the first conductivity type, and the second well region may be disposed on the internal side of the first well region in the first and second directions. The plurality of gate structures 313 and the plurality of active regions 311 and 312 may be formed in the second well region, and the plurality of active regions 311 and 312 may be doped with impurities of the first conductivity type. When the switch element 310 is implemented as an NMOS transistor, impurities of the first conductivity type may be N-type impurities, and impurities of the second conductivity type may be P-type impurities.

A first impurity region 301 may be formed in the first well region. The second impurity region 302 formed in the second well region together with the switch element 310 may provide a body of the switch element 310. Differently from the plurality of active regions 311 and 312, the second impurity region 302 may be doped with impurities of the second conductivity type.

A third well region surrounding the first well region may be further formed on an external side of the first well region, and a third impurity region 303 may be formed in the third well region. The third well region and the third impurity region 303 may be doped with impurities of the second conductivity type.

Referring to FIG. 4, a dummy gate structure 320 may be formed in the first impurity region 301. For example, the dummy gate structure 320 may have a shape corresponding to the first impurity region 301, and may have a shape surrounding the region in which the plurality of active regions 311 and 312, the plurality of gate structures 313, and the third impurity region 303 are disposed as illustrated in FIG. 4.

The dummy gate structure 320 may include a dummy gate electrode layer formed of a conductive material and a dummy gate insulating layer disposed between the dummy gate electrode layer and the first impurity region 301. The dummy gate electrode layer may be electrically connected to the plurality of gate structures 313, and partial regions exposed and not covered by the dummy gate structure 320 among the first impurity region 301 may be connected to the plurality of first active regions 311. Accordingly, a capacitor provided by the dummy gate structure 320 and the first impurity region 301 may be connected between a gate and a drain of the switch element 310, as described with reference to FIG. 2B.

As illustrated in FIG. 4, in one or more embodiments, instead of forming a separate MOS capacitor, the capacitor required for the ESD protective circuit 300 may be implemented by forming a dummy gate structure 320 in at least one of the impurity regions 301-303. Accordingly, as compared to a structure including an MOS capacitor requiring an active region and a gate structure, an area occupied by the ESD protective circuit 300 may be reduced and integration density of the semiconductor device including the ESD protective circuit 300 may be improved.

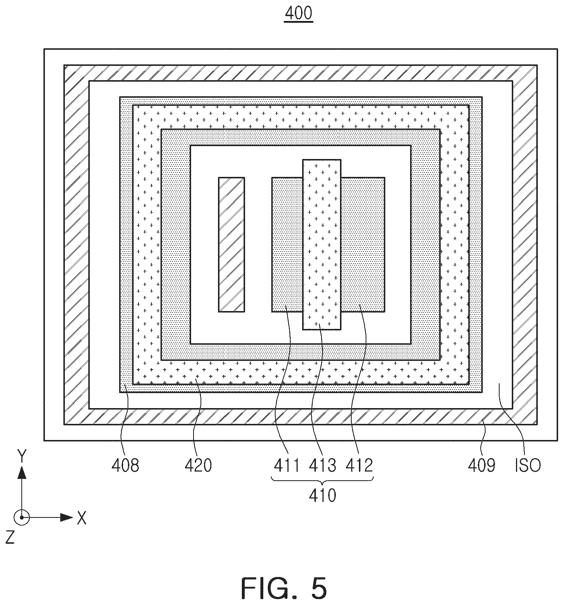

FIGS. 5 to 8 are diagrams illustrating an ESD protective circuit according to one or more embodiments.

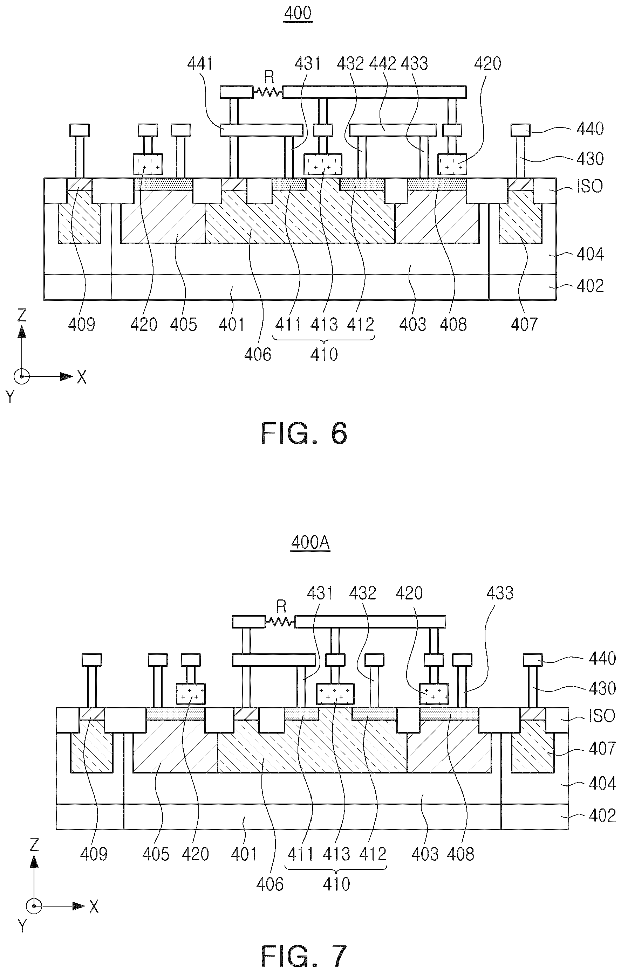

Referring to FIGS. 5 and 6, a substrate on which the ESD protective circuit 400 according to one or more embodiments is formed may include a first buried layer 401, a second buried layer 402, a first epitaxial layer 403, a second epitaxial layer 404, a first well region 405, a second well region 406, a third well region 407, a first impurity region 408, a second impurity region 409, and a device isolation film ISO. The first buried layer 401, the first epitaxial layer 403, the second buried layer 402, the second epitaxial layer 404, the first well region 405, the second well region 406, the third well region 407, the first impurity region 408, and the second impurity region 409 may be formed by a process of injecting impurities.

For example, the first buried layer 401, the first epitaxial layer 403, the first well region 405, and the first impurity region 408 may be doped with impurities of a first conductivity type, and the second buried layer 402, the second epitaxial layer 404, the second well region 406, the third well region 407, and the second impurity region 409 may be doped with impurities of a second conductivity type. In FIGS. 5 and 6, impurities of the first conductivity type may be N-type impurities, and impurities of the second conductivity type may be P-type impurities, but embodiments are not limited thereto.

The device isolation film ISO may be disposed between the first impurity region 408 and the second impurity region 409, and may be formed of an insulating material such as silicon oxide, silicon nitride, or silicon oxynitride. Referring to FIG. 6, a thickness of the device isolation film ISO in the third direction (e.g., Z-axis direction) may be greater than thicknesses of the first impurity region 408 and the second impurity region 409, and may be smaller than thicknesses of the first to third well regions 405-407.

Among the first impurity region 408 doped with impurities of the first conductivity type, partial regions disposed in the second well region 406 may provide active regions 411 and 412 of a switch element included in an ESD protective circuit 400. At least one region of the second impurity region 409 doped with impurities of the second conductivity type, disposed in the second well region 406, may provide a body region of the switch element. A gate structure 413 may be disposed between active regions 411 and 412. The active regions 411 and 412 and the gate structure 413 may provide a switch element 410 of the ESD protective circuit 400. FIGS. 5 and 6 illustrate the example in which the first active region 411 and the second active region 412 are disposed in the second well region 406, and a gate structure 413 may be disposed therebetween, but one or more embodiments thereof are not limited thereto.

As an example, similar to FIG. 4, a plurality of the first active regions 411, a plurality of the second active regions 412, and a plurality of the gate structures 413 may be disposed in the second well region 406. In this case, the plurality of first active regions 411 may be connected to each other, the plurality of second active regions 412 may be connected to each other, and the plurality of gate structures 413 may be connected to each other.

Referring back to FIGS. 5 and 6, the first active region 411 may provide a source for the switch element 410, and the second active region 412 may provide a drain for the switch element 410. The first active region 411 may be electrically connected to the second impurity region 409, providing a body of the switch element 410, by a contact 430 and a wiring pattern of the plurality of wiring patterns 440. The second active region 412 may be electrically connected to the first impurity region 408 formed in the first well region 405 by the contact 430 and a wiring pattern of the plurality of wiring patterns 440. A first active contact 431 may be connected to the first active region 411, a second active contact 432 may be connected to the second active region 412, and a first contact 433 may be connected to the first impurity region 408.

A dummy gate structure 420 may be formed on the first impurity region 408. The dummy gate structure 420 may include a dummy gate electrode layer formed of a conductive material such as polysilicon, and a dummy gate insulating layer disposed between the dummy gate electrode layer and the first impurity region 408, and the dummy gate electrode layer, the first impurity region 408, and the dummy gate insulating layer may provide a capacitor. The dummy gate structure 420 may be disposed on one side of the first contact 433 in a first direction (e.g., X-axis direction) parallel to an upper surface of the substrate. Also, the second active contact 432 and the first contact 433 may be disposed between the dummy gate structure 420 and the gate structure 413 in the first direction (e.g., the X-axis direction).

Accordingly, the second active region 412 providing a drain of the switch element 410 may be connected to the first impurity region 408, which is a first electrode of electrodes of the capacitor, through the contact 430 and a wiring pattern of the plurality of wiring patterns 440. Also, the gate structure 413 providing a gate of the switch element 410 may be connected to the dummy gate electrode layer, which is a second electrode of the electrodes of the capacitor, through the contact 430 and a wiring pattern of the plurality of wiring patterns 440. Consequently, similar to FIG. 2B, the capacitor provided by the dummy gate structure 420 and the first impurity region 408 may be connected between a gate and a drain of the switch element 410. The wiring pattern of the plurality of wiring patterns 440 connecting the gate structure 413 to the dummy gate structure 420 may be connected to the second impurity region 409 providing a body of the switch element 410 and the first active region 411 providing a source of the switch element 410 through a resistor element R.

In one or more embodiments, the ESD protective circuit 400 may be formed in the first well region 405 and the second well region 406 having a twin-well structure. The first well region 405 and the second well region 406 may be formed in the first epitaxial layer 403 and may contact each other.

The second well region 406 may be disposed on an internal side of the first well region 405 in a direction parallel to an upper surface of the substrate (for example, the first direction (e.g., X-axis direction) and the second direction (e.g., Y-axis direction)). The first and second active regions 411 and 412 providing the switch element 410 and the gate structure 413 included in the ESD protective circuit 400 may be formed in the second well region 406, and the dummy gate structure 420 providing a capacitor may be formed in the first impurity region 408 of the first well region 405.

The ESD protective circuit 400A according to one or more embodiments illustrated in FIG. 7 may have a structure similar to that of the ESD protective circuit 400 as described with reference to FIGS. 5 and 6. However, as illustrated in FIG. 7, the dummy gate structure 420 may be disposed closer to the device isolation film ISO between the first well region 405 and the second well region 406 than to the device isolation film ISO between the first well region 405 and the third well region 407.

Accordingly, the dummy gate structure 420 may be disposed between the first contact 433 and the second active contact 432 in the first direction (e.g., X-axis direction). The second impurity region 409 formed in the third well region 407 providing the source of the switch element 410, and the first active region 411 providing the source may be connected to the first power wiring pattern 441 supplying a first power voltage. The first impurity region 408 in which the dummy gate structure 420 is disposed, and the first impurity region 408 providing the drain of the switch element 410 may be connected to a second power wiring pattern 442 supplying a second power voltage greater than the first power voltage.

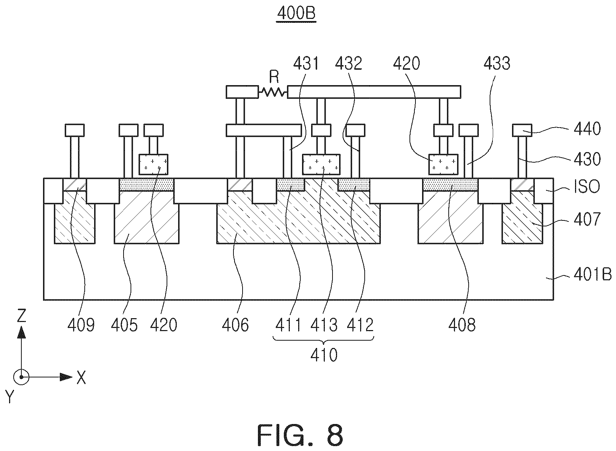

The ESD protective circuit 400B illustrated in FIG. 8 may have a structure similar to that of the ESD protective circuit 400A in FIG. 7. However, in FIG. 8, buried layers 401, 402 and epitaxial layers 403, 404 may not be formed, and the first well region 405, the second well region 406 and the third well region 407 may be formed in the substrate 401B having P-type conductivity.

Referring to FIG. 8, the dummy gate structure 420 may be disposed between the first contact 433 and the second active region 412 in the first direction (e.g., X-axis direction). However, the dummy gate structure 420 may be disposed as illustrated in FIG. 6. For example, similar to FIG. 6, the first contact 433 connected to the first impurity region 408 in which the dummy gate structure 420 is disposed may be disposed between the dummy gate structure 420 and the gate structure 413.

In the ESD protective circuits 400, 400A, and 400B according to one or more embodiments described with reference to FIGS. 5 to 8, a width of the dummy gate structure 420 may be larger than a width of the gate structure 413. The width of the dummy gate structure 420 may be determined depending on a level of capacitance required to implement the ESD protective circuits 400, 400A and 400B.

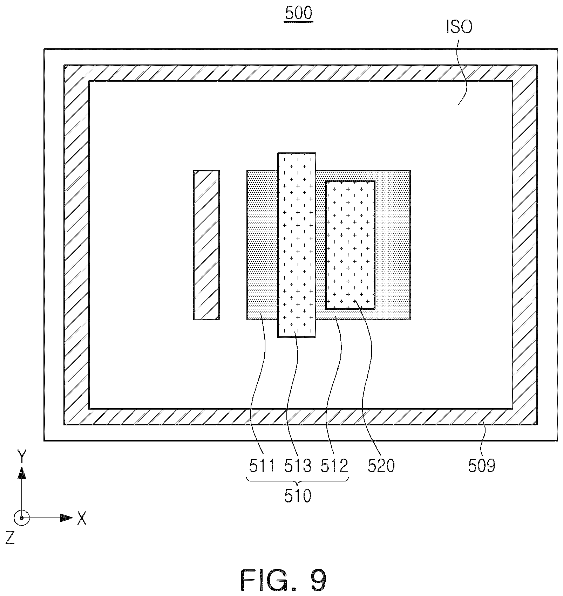

FIGS. 9 to 11 are diagrams illustrating an ESD protective circuit according to one or more embodiments.

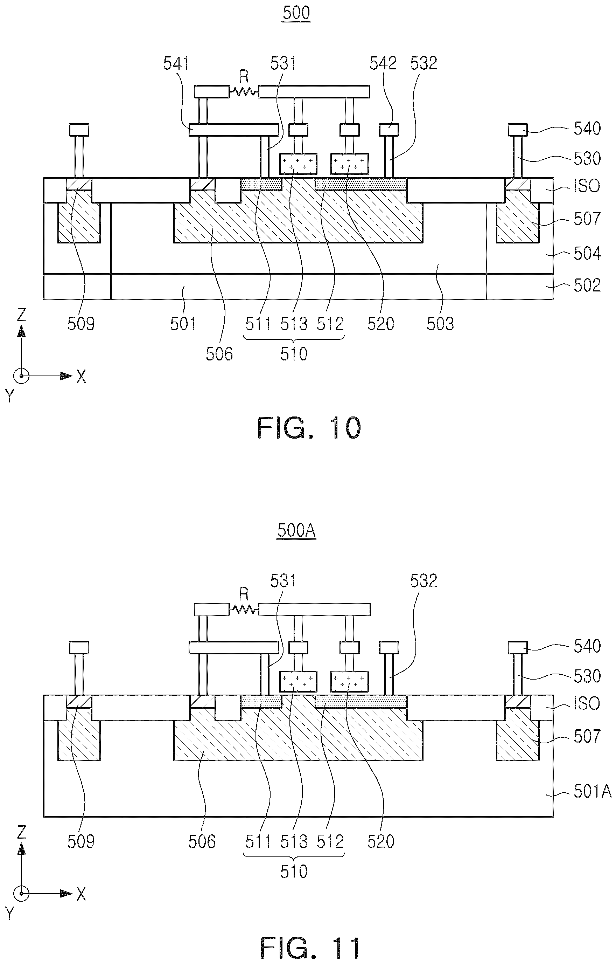

Referring to FIGS. 9 and 10, a substrate on which the ESD protective circuit 500 according to one or more embodiments is formed may include a first buried layer 501, a second buried layer 502, a first epitaxial layer 503, a second epitaxial layer 504, a second well region 506, a third well region 507, a second impurity region 509, and a device isolation film ISO. In one or more embodiments illustrated in FIGS. 9 and 10, the ESD protective circuit 500 may not have a twin-well structure. Accordingly, the structure corresponding to the first well region 405 and the first impurity region 408 described with reference to FIGS. 5 to 8 may not be included in the ESD protective circuit 500.

The first buried layer 501 and the first epitaxial layer 503 may be doped with impurities of the first conductivity type, and the second buried layer 502, the second epitaxial layer 504, the second well region 506, the third well region 507, and the second impurity region 509 may be doped with impurities of the second conductivity type. Each of the first active region 511 providing a source of the switch element 510 and the second active region 512 providing a drain may be doped with impurities of the first conductivity type. The gate structure 513 may be disposed between the first active region 511 and the second active region 512 in the first direction (e.g., X-axis direction).

The first active region 511 may be formed in the second well region 506 of the second impurity region 509 by the first active contact 531 and a wiring pattern of the plurality of wiring patterns 540, may be connected to a region providing a body of the switch element 510, and may be connected to one end of the resistor element R. The other end of resistor element R may be connected to a gate structure 513 and a dummy gate structure 520 through a wiring pattern of the plurality of wiring patterns 540. The wiring pattern connecting the second impurity region 509 providing a body of the switch element 510 to the first active region 511 may be the first power wiring pattern 541 supplying a first power voltage. For example, the first power voltage may be VSS among the power voltages described above with reference to FIG. 1.

In one or more embodiments illustrated in FIGS. 9 and 10, a dummy gate structure 520 to replace the MOS capacitor may be formed on the second active region 512 providing a drain of the switch element 510. Referring to FIGS. 9 and 10, the dummy gate structure 520 may be disposed adjacent to the gate structure 513 in the first direction (e.g., X-axis direction). In the first direction (e.g., X-axis direction), the dummy gate structure 520 may be disposed between the second active contact 532 and the gate structure 513, which may be in contact with the second active region 512.

The dummy gate structure 520 may be connected to the gate structure 513 by the contact 530 and a wiring pattern of the plurality of wiring patterns 540, and the second active region 512 may be connected to a second power wiring pattern 542 supplying a second power voltage greater than the first power voltage. For example, the second power voltage may be VDD among power voltages described above with reference to FIG. 1. Accordingly, the capacitor provided by the dummy gate structure 520 and the second active region 512 may be connected between a gate of the switch element 510 and the second power pad to which the second power voltage is input.

In FIGS. 9 and 10, the first active region 511 and the second active region 512 may be disposed in the second well region 506, and a gate structure 513 may be disposed therebetween, but embodiments are not limited thereto. For example, similar to FIG. 4, a plurality of the first active regions 511, a plurality of the second active regions 512, and a plurality of the gate structures 513 may be disposed in the second well region 506. In this case, the plurality of first active regions 511 may be connected to each other, the plurality of second active regions 512 may be connected to each other, and the plurality of gate structures 513 may be connected to each other.

The ESD protective circuit 500A according to one or more embodiments illustrated in FIG. 11 may have a structure similar to that of the ESD protective circuit 500 described with reference to FIGS. 9 and 10. However, in FIG. 11, buried layers 501 and 502 and epitaxial layers 503 and 504 may not be formed, and a second well region 506 and a third well region 507 may be formed in substrate 501A having a P-type conductivity.

In the ESD protective circuits 500 and 500A according to the example embodiments described with reference to FIGS. 9 to 11, a width of the dummy gate structure 520 may be larger than a width of the gate structure 513. The width of the dummy gate structure 520 may be determined depending on a level of capacitance required for each of the ESD protective circuits 500 and 500A, and accordingly, the width of dummy gate structure 520 may be equal to or smaller than the width of gate structure 513 in example embodiments.

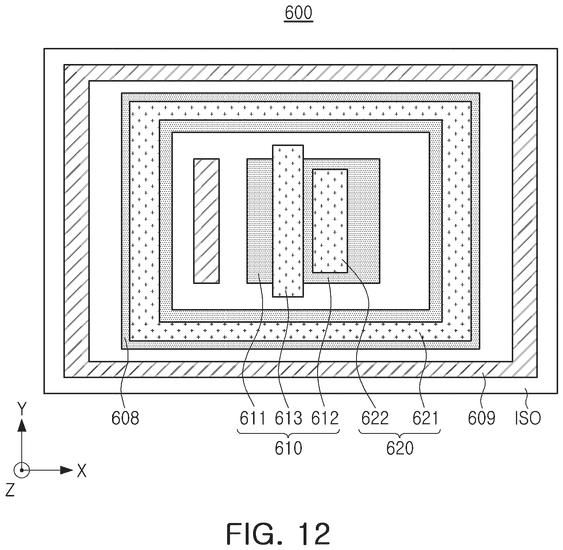

FIGS. 12 to 14 are diagrams illustrating an ESD protective circuit according to one or more embodiments.

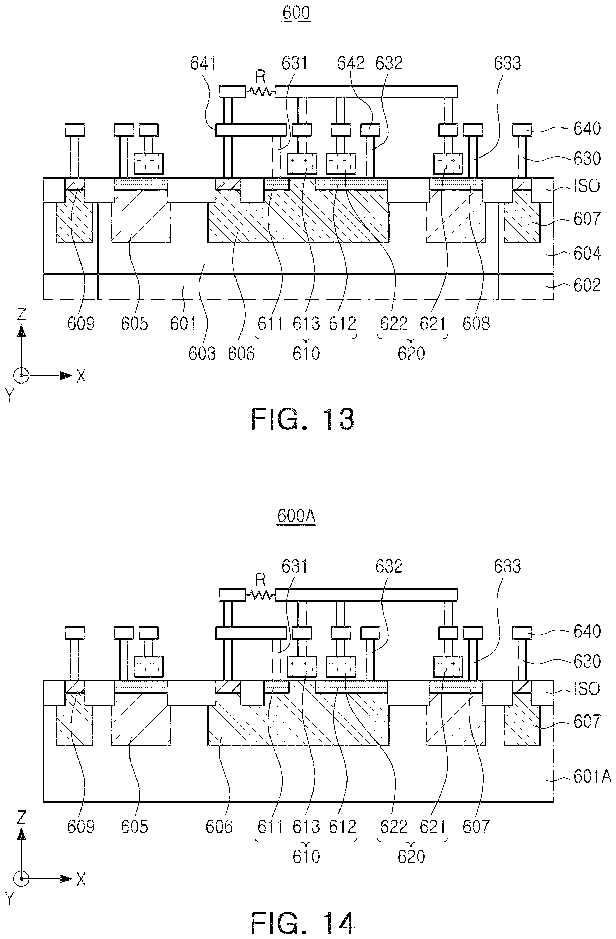

Referring first to FIGS. 12 and 13, a substrate on which the ESD protective circuit 600 according to one or more embodiments is formed may include a first buried layer 601, a second buried layer 602, a first epitaxial layer 603, a second epitaxial layer 604, a first well region 605, a second well region 606, a third well region 607, a first impurity region 608, a second impurity region 609, and a device isolation film ISO. The first buried layer 601, the first epitaxial layer 603, the first well region 605, and the first impurity region 608, may be doped with impurities of a first conductivity type, and the second buried layer 602, the second epitaxial layer 604, the second well region 606, the third well region 607, the second impurity region 609 may be doped with impurities of a second conductivity type.

The first active region 611 and the second active region 612 of the first impurity region 608 may provide a source and a drain of the switch element 610, respectively. The gate structure 613 may be disposed between the first active region 611 and the second active region 612 in the first direction (e.g., X-axis direction).

The first active region 611 may be connected to the second impurity region 609 providing a body of the switch element 610 by a first active contact 631 and a wiring pattern of the plurality of wiring patterns 640, and may be connected to one end of the resistor element R. The other end of resistor element R may be connected to a gate structure 613 and a dummy gate structure 620 through a wiring pattern of the plurality of wiring patterns 640. The wiring pattern connecting the second impurity region 609 providing the body of the switch element 610 to the first active region 611 may be the first power wiring pattern 641 supplying a first power voltage having a relatively low level. The second active region 612 providing a drain of the switch element 610 may be electrically connected to the second power wiring pattern 642 supplying a second power voltage having a level higher than a level of the first power voltage.

As illustrated in FIGS. 12 and 13, the dummy gate structure 620 of the ESD protective circuit 600 may include a first dummy gate structure 621 and a second dummy gate structure 622. The first dummy gate structure 621 may be formed on the first impurity region 608, and the second dummy gate structure 622 may be formed on the second active region 612 providing a drain of the switch element 610. The first dummy gate structure 621 and the second dummy gate structure 622 may be electrically connected to the gate structure 613.

The first dummy gate structure 621 may be disposed between the first contact 633 and the second active contact 632 in the first direction (e.g., X-axis direction). The second dummy gate structure 622 may be disposed between the gate structure 613 and the second active contact 632. However, in one or more embodiments, the first contact 633 may be disposed between the first dummy gate structure 621 and the second dummy gate structure 622 in the first direction (e.g., X-axis direction).

By forming the first dummy gate structure 621 and the second dummy gate structure 622 as in FIGS. 12 and 13, capacitance of a capacitor included in the ESD protective circuit 600 may be increased. Also, in one or more embodiments, when a plurality of the first active regions 611, a plurality of the second active regions 612 and a plurality of the gate structures 613 of the switch element 610 are implemented, the number of the second dummy gate structures 622 may be two or more.

The ESD protective circuit 600A illustrated in FIG. 14 may have a structure similar to that of the ESD protective circuit 600 in FIGS. 12 and 13. However, in one or more embodiments illustrated in FIG. 14, buried layers 601 and 602 and epitaxial layers 603 and 604 may not be formed, and first to third well regions 605-607 may be formed in a substrate 601A having P-type conductivity.

In the ESD protective circuits 600 and 600A according to one or more embodiments, a width of the first dummy gate structure 621 may be larger than a width of the gate structure 613. In one or more embodiments, a width of the second dummy gate structure 622 may be larger or smaller than a width of the gate structure 613. By forming the width of the second dummy gate structure 622 to be smaller than the width of the gate structure 613, an increase in area of the second active region 612 may be reduced and integration density of each of the ESD protective circuits 600 and 600A may be improved. In one or more embodiments, the width of the second dummy gate structure 622 may be smaller than the width of the first dummy gate structure 621.

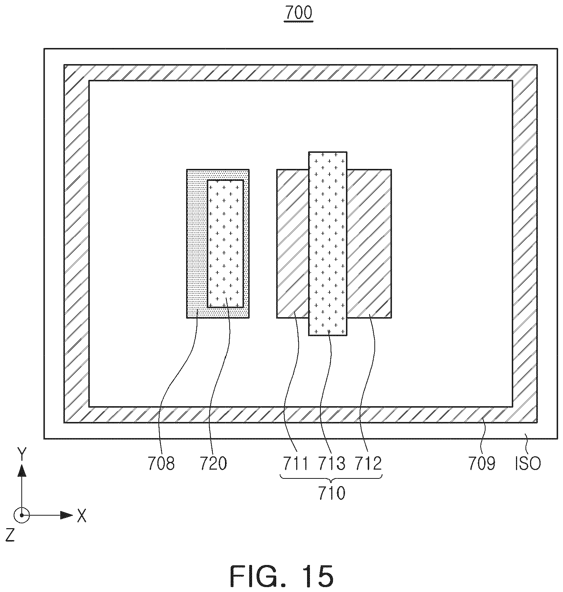

FIGS. 15 to 17 are diagrams illustrating an ESD protective circuit according to one or more embodiments.

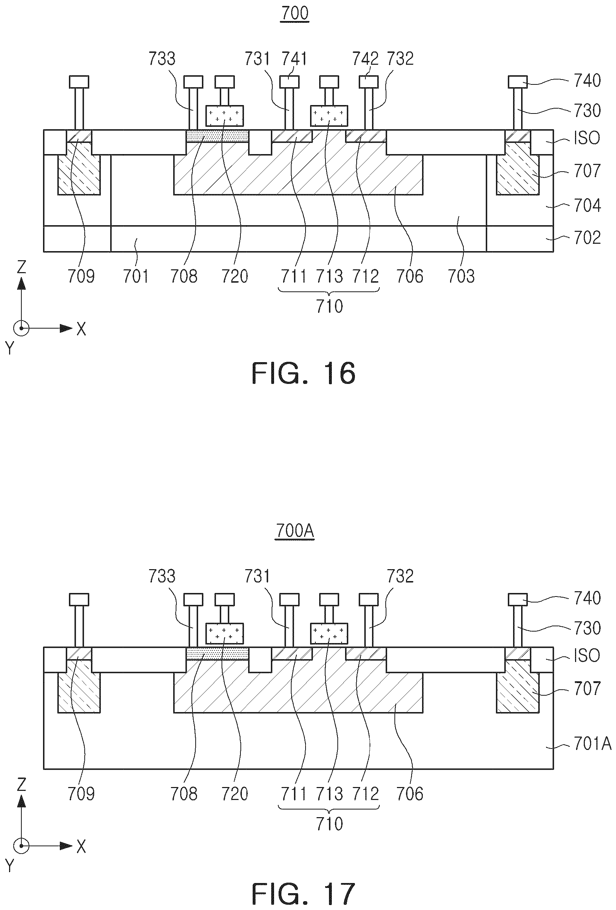

Referring to FIGS. 15 and 16, a substrate on which an ESD protective circuit 700 according to one or more embodiments is formed may include a first buried layer 701, a second buried layer 702, a first epitaxial layer 703, a second epitaxial layer 704, a second well region 706, a third well region 707, a first impurity region 708, a second impurity region 709, and a device isolation film ISO. In one or more embodiments illustrated in FIGS. 15 and 16, the ESD protective circuit 700 may not have a twin-well structure.

The first buried layer 701, the first epitaxial layer 703, the second well region 706, and the first impurity region 708 may be doped with impurities of a first conductivity type, and the second buried layer 702, the second epitaxial layer 704, the third well region 707, and the second impurity region 709 may be doped with impurities of a second conductivity type. Each of the first active region 711 providing the source of switch element 710, and the second active region 712 providing the drain may be doped with impurities of the second conductivity type. The gate structure 713 may be disposed between the first active region 711 and the second active region 712 in the first direction (X-axis direction).

In the ESD protective circuit 700 described with reference to FIGS. 15 and 16, the switch element 710 may be implemented as a PMOS transistor. Accordingly, the second well region 706 may be doped with N-type impurities, and each of the first active region 711 and the second active region 712 may be doped with P-type impurities. The first impurity region 708 providing a body of a switch element 710 may be doped with N-type impurities.

The capacitor included in the ESD protective circuit 700 may be provided by a first impurity region 708 formed in the second well region 706, and a dummy gate structure 720 formed on the first impurity region 708. The dummy gate structure 720 may be connected to the gate structure 713 by a contact 730 and a wiring pattern of the plurality of wiring patterns 740. The dummy gate structure 720 may be disposed between the first contact 733 and the first active contact 731 connected to the first impurity region 708.

The plurality of wiring patterns 740 may include a first power wiring pattern 741 supplying a relatively low first power voltage, and a second power wiring pattern 742 supplying a second power voltage having a level higher than that of the first power voltage. Since the switch element 710 is implemented as a PMOS transistor, the first active region 711 providing a source may be connected to the second power wiring pattern 742 on a relatively high level, and the second active region 712 providing a drain may be connected to the first power wiring pattern 741 through the second active contact 732. The first active region 711 may be connected to the first impurity region 708 providing a body of the switch element 710 by the first active contact 731 and the wiring pattern 740.

Referring to FIGS. 15 and 16, a dummy gate structure 720 may be formed on the first impurity region 708 providing a body of the switch element 710. The capacitor included in the ESD protective circuit 700 may be provided by the dummy gate structure 720 and the first impurity region 708. For example, the dummy gate electrode layer included in the dummy gate structure 720 may provide a first electrode of a capacitor, the first impurity region 708 may provide a second electrode of a capacitor, and the dummy gate insulating layer included in the dummy gate structure 720 may provide a dielectric of the capacitor.

The ESD protective circuit 700A in FIG. 17 may have a structure similar to that of the ESD protective circuit 700 in FIGS. 15 and 16. However, in FIG. 17, buried layers 701 and 702 and epitaxial layers 703 and 704 may not be formed, and a second well region 706 and a third well region 707 may be formed in a substrate 701A having P-type conductivity.

In the ESD protective circuits 700 and 700A according to one or more embodiments described with reference to FIGS. 15 to 17, a width of the dummy gate structure 720 may be larger than a width of the gate structure 713. However, the width of the dummy gate structure 720 may be determined depending on a level of capacitance required for each of the ESD protective circuits 700 and 700A, and accordingly, the width of dummy gate structure 720 may be equal to or smaller than the width of gate structure 713 in example embodiments.

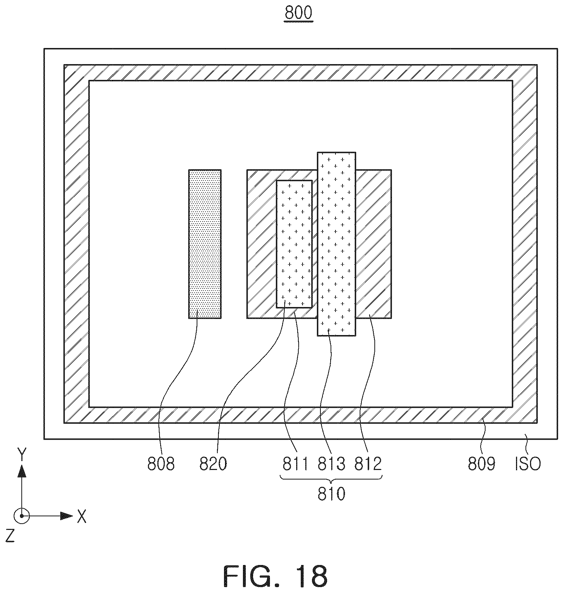

FIGS. 18 to 20 are diagrams illustrating an ESD protective circuit according to one or more embodiments.

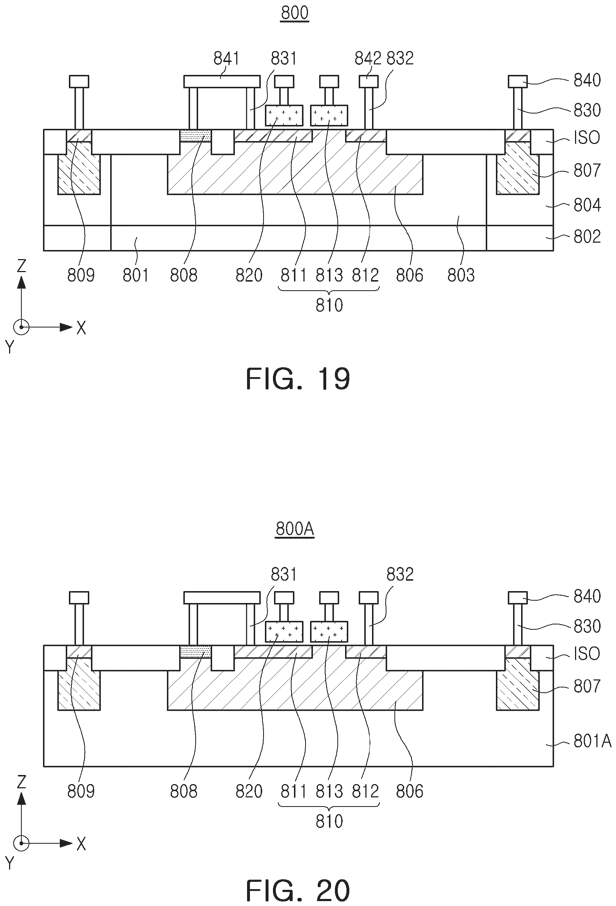

Referring to FIGS. 18 and 19, a substrate on which the ESD protective circuit 800 according to one or more embodiments is formed may include a first buried layer 801, a second buried layer 802, a first epitaxial layer 803, a second epitaxial layer 804, a second well region 806, a third well region 807, a second impurity region 809, and a device isolation film ISO. In one or more embodiments illustrated in FIGS. 18 and 19, an ESD protective circuit 800 may not have a twin-well structure, and accordingly, the first well region disposed between the second well region 806 and the third well region 807 may not be present.

The first buried layer 801, the first epitaxial layer 803, the second well region 806, and the first impurity region 808 may be doped with impurities of first conductivity type, and the second buried layer 802, the second epitaxial layer 804, the third well region 807, and the second impurity region 809 may be doped with impurities of a second conductivity type. Each of the first active region 811 providing a source of the switch element 810 and the second active region 812 providing a drain may be doped with impurities of the second conductivity type.

Impurities of the first conductivity type may be N-type impurities, and impurities of the second conductivity type may be P-type impurities. Accordingly, the switch element 810 provided by the first active region 811, the second active region 812 and the gate structure 813 may be a PMOS transistor. The first active region 811 may be formed in the second well region 806 of the first impurity region 808 by a contact 830 and a wiring pattern of the plurality of wiring patterns 840 and may be connected to a region providing a body of the switch element 810.

The plurality of wiring patterns 840 may include a first power wiring pattern 841 supplying a first power voltage, and a second power wiring pattern 842 supplying a second power voltage greater than the first power voltage. Since the switch element 810 is implemented as a PMOS transistor, the first active region 811 may be connected to the second power wiring pattern 842 by the first active contact 831, and the second active region 812 may be connected to the first power wiring pattern 841 by the second active contact 832.

In one or more embodiments illustrated in FIGS. 18 and 19, a dummy gate structure 820 for providing a capacitor may be formed in the first active region 811 providing a source for the switch element 810. Referring to FIGS. 18 and 19, the dummy gate structure 820 may be disposed adjacent to a gate structure 813 in the first direction (e.g., X-axis direction). Accordingly, the dummy gate structure 820 may be disposed between the first active contact 831 and the gate structure 813, and may contact first active region 811 in the first direction (e.g., X-axis direction). The positions of the dummy gate structure 820 and the first active contact 831 in the first direction (e.g., X-axis direction) may be switched with each other.

The dummy gate structure 820 may be connected to the gate structure 813 by a contact 830 and a wiring pattern of the plurality of wiring patterns 840. As described above, the first active region 811 may be connected to the second power wiring pattern 842, such that the dummy gate structure 820 and the capacitor provided by the first active region 811 may be connected between a gate of switch element 810 and the second power pad to which the second power voltage is input.

In FIGS. 18 and 19, the first active region 811 and the second active region 812 may be disposed in the second well region 806, and the gate structure 813 may be disposed therebetween, but embodiments are not limited thereto. For example, a plurality of the first active regions 811, a plurality of the second active regions 812, and a plurality of the gate structures 813 may be disposed in the second well region 806. In this case, the number of the dummy gate structures 820 formed in the first active region 811 may also be two or more.

The ESD protective circuit 800A in FIG. 20 may have a structure similar to that of the ESD protective circuit 800 in FIGS. 18 and 19. However, in FIG. 20, buried layers 801 and 802 and epitaxial layers 803 and 804 may not be formed, and the second well region 806 and the third well region 807 may be formed in the substrate 801A having P-type conductivity.

In the ESD protective circuits 800 and 800A according to one or more embodiments described with reference to FIGS. 18 to 20, the width of the dummy gate structure 820 may be larger than the width of the gate structure 813. The width of the dummy gate structure 820 may be determined depending on a level of capacitance required for each of the ESD protective circuits 800 and 800A, and accordingly, the width of the dummy gate structure 820 may be equal to or smaller than the width of the gate structure 813.

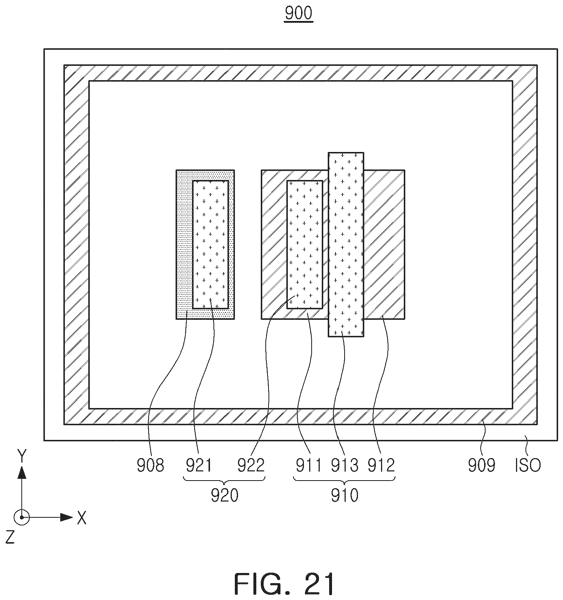

FIGS. 21 to 23 are diagrams illustrating an ESD protective circuit according to one or more embodiments.

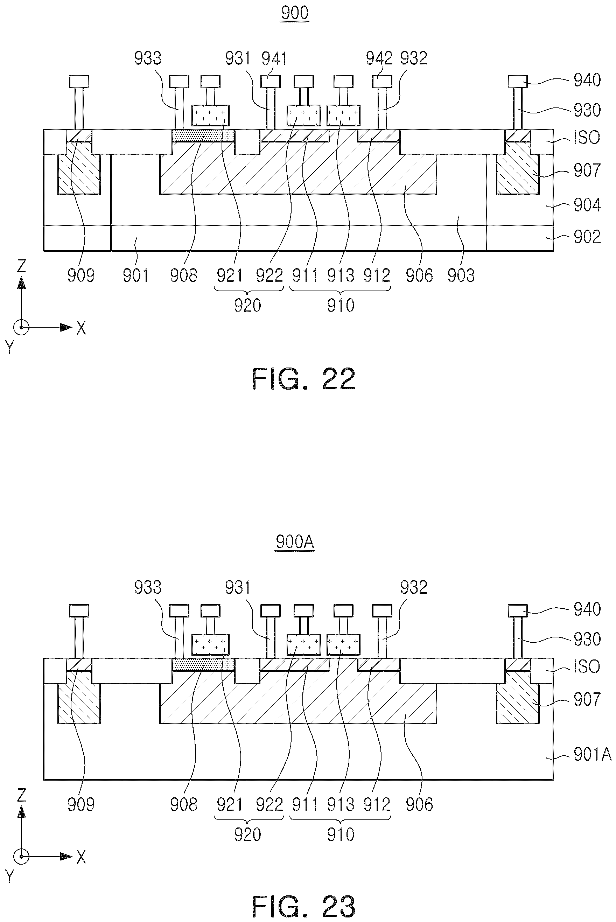

Referring to FIGS. 21 and 22, an ESD protective circuit 900 according to one or more embodiments may be formed on a substrate including a first buried layer 901, a second buried layer 902, a first epitaxial layer 903, a second epitaxial layer 904, a second well region 906, a third well region 907, a second impurity region 909, and a device isolation film ISO. In one or more embodiments illustrated in FIGS. 21 and 22, the ESD protective circuit 900 may not have a twin-well structure, and the switch element included in the ESD protective circuit 900 may be implemented as a PMOS transistor.

The first buried layer 901, the first epitaxial layer 903, the second well region 906, and the first impurity region 908 may be doped with impurities of a first conductivity type, and the second buried layer 902, the second epitaxial layer 904, the third well region 907, and the second impurity region 909 may be doped with impurities of a second conductivity type. The first active region 911 providing a source of the switch element 910, and the second active region 912 providing a drain may be doped with impurities of the second conductivity type. In other words, impurities of the first conductivity type may be N-type impurities, and impurities of the second conductivity type may be P-type impurities.

The first active region 911 may be formed in the second well region 906 of the first impurity region 908 and may be connected to a region providing a body of the switch element 910 by a first active contact 931 and a wiring pattern of the plurality of wiring patterns 940. The plurality of wiring patterns 940 may include a first power wiring pattern 941 supplying a first power voltage, and a second power wiring pattern 942 supplying a second power voltage greater than the first power voltage. Since the switch element 910 is implemented as a PMOS transistor, the first active region 911 may be connected to the second power wiring pattern 942 through the first active contact 931, and the second active region 912 may be connected to the first power wiring pattern 941 through the second active contact 932.

The dummy gate structure 920 of the ESD protective circuit 900 in FIGS. 21 and 22 may include a first dummy gate structure 921 and a second dummy gate structure 922. The first dummy gate structure 921 may be disposed on the first impurity region 908 providing a body of the switch element 910, and the second dummy gate structure 922 may be disposed on the first active region 911 providing a source of the switch element 910. The first dummy gate structure 921 and the second dummy gate structure 922 may be electrically connected to the gate structure 913.

Referring to FIG. 21, the first active contact 931 connected to the first active region 911 may be disposed between the first dummy gate structure 921 and the second dummy gate structure 922 in the first direction (e.g., X-axis direction) parallel to an upper surface of the substrate. The first dummy gate structure 921 may be disposed between the first active contact 931 and the first contact 933. Also, the second dummy gate structure 922 and the gate structure 913 may be adjacent to each other in the first direction. However, the arrangement of the first dummy gate structure 921 and the second dummy gate structure 922 is not limited thereto.

The first dummy gate structure 921 and the second dummy gate structure 922 may be connected to each other and may provide one of electrodes of a capacitor. The other of the electrodes of the capacitor may be provided by contacts 931 and 933 connected to the first active region 911 and the first impurity region 908.

In one or more embodiments described with reference to FIGS. 20 and 21, the first active region 911 and the second active region 912 may be disposed in the second well region 906, and the gate structure 913 may be disposed therebetween, but embodiments are not limited thereto. For example, a plurality of the first active regions 911, a plurality of the second active regions 912, and a plurality of the gate structures 913 may be disposed in the second well region 906. In this case, the number of the second dummy gate structures 922 formed in the first active region 911 may also be two or more.

The ESD protective circuit 900A in FIG. 23 may have a structure similar to that of the ESD protective circuit 900 in FIGS. 21 and 22. However, in FIG. 23, buried layers 901 and 902 and epitaxial layers 903 and 904 may not be formed, and the second well region 906 and the third well region 907 may be formed in a substrate 901A having P-type conductivity.

In the ESD protective circuits 900 and 900A according to one or more embodiments described with reference to FIGS. 21 to 23, the width of the first dummy gate structure 921 may be larger than the width of the gate structure 613. In one or more embodiments, a width of the second dummy gate structure 922 may be larger or smaller than a width of the gate structure 913. For example, by forming the width of the second dummy gate structure 922 to be smaller than the width of the gate structure 913, an increase in an area of the second active region 912 may be reduced and integration density of each of the ESD protective circuits 900 and 900A may be improved. In example embodiments, a width of the second dummy gate structure 922 may be smaller than a width of the first dummy gate structure 921.

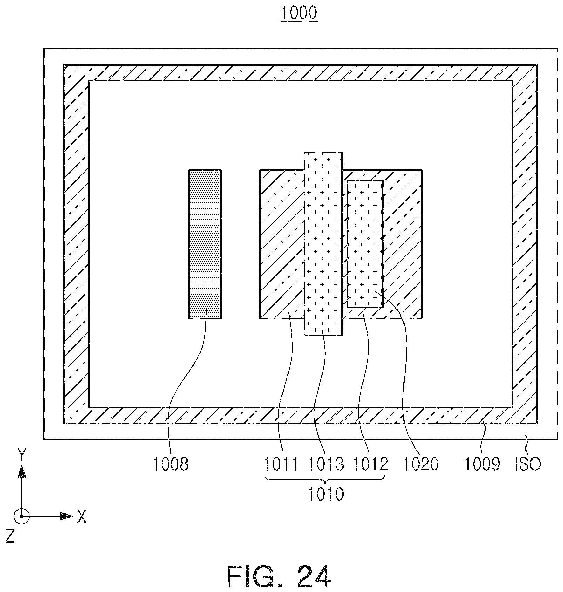

FIGS. 24 to 26 are diagrams illustrating an ESD protective circuit according to one or more embodiments.

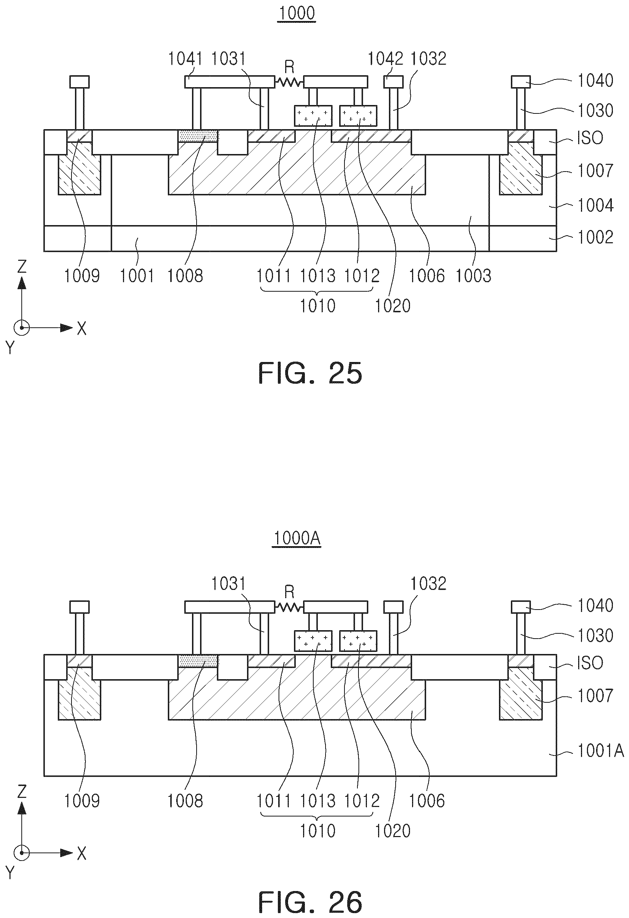

Referring to FIGS. 24 and 25, a substrate on which the ESD protective circuit 1000 according to one or more embodiments is formed may include a first buried layer 1001, a second buried layer 1002, a first epitaxial layer 1003, a second epitaxial layer 1004, a second well region 1006, a third well region 1007, a first impurity region 1008, a second impurity region 1009, and a device isolation film ISO. The first buried layer 1001, the first epitaxial layer 1003, the second well region 1006, and the first impurity region 1008 may be doped with impurities of the first conductivity type, and the second buried layer 1002, the second epitaxial layer 1004, the third well region 1007, and the second impurity region 1009 may be doped with impurities of the first conductivity type. Impurities of the first conductivity type may be N-type impurities, and impurities of the second conductivity type may be P-type impurities.

In one or more embodiments illustrated in FIGS. 24 and 25, the ESD protective circuit 1000 may not have a twin-well structure. Accordingly, the dummy gate structure 1020 to provide a capacitor may not be disposed in another well region surrounding the second well region 1006. Referring to FIGS. 24 and 25, the dummy gate structure 1020 may be formed on the second active region 1012 providing a drain of the switch element 1010. For example, the dummy gate structure 1020 may be arranged side by side with the gate structure 1013. However, in one or more embodiments, a position of the dummy gate structure 1020 in the first direction (e.g., X-axis direction) may vary, and for example, the second active contact 1032 may be disposed between the dummy gate structure 1020 and the gate structure 1013.

The first active region 1011 providing the source of the switch element 1010, may be connected to the first impurity region 1008 providing a body of the switch element 1010 through a first active contact 1031 and a wiring pattern of the plurality of wiring patterns 1040. For example, the switch element 1010 may be implemented as a PMOS transistor, the second active region 1012 may be connected to the first power wiring pattern 1041 supplying a first power voltage, and the first active region 1011 and the first impurity region 1008 may be connected to a second power wiring pattern 1042 supplying a second power voltage greater than the first power voltage. The resistor element R may be connected between the gate structure 1013 and the first active region 1011.

According to one or more embodiments, the number of each of the first active region 1011, the second active region 1012, and the gate structure 1013 disposed in the second well region 1006 may be two or more. In this case, the plurality of first active regions 1011 may be connected to each other, the plurality of second active regions 1012 may be connected to each other, and the plurality of gate structures 1013 may be connected to each other such that a switch element may be provided.

The ESD protective circuit 1000A in FIG. 26 may have a structure similar to that of the ESD protective circuit 1000 in FIGS. 24 and 25. However, in FIG. 26, buried layers 1001 and 1002 and epitaxial layers 1003 and 1004 may not be formed, and a second well region 1006 and a third well region 1007 may be formed in a substrate 1001A having P-type conductivity

In the ESD protective circuits 1000 and 1000A according to one or more embodiments described with reference to FIGS. 24 to 26, a width of the dummy gate structure 1020 may be larger than a width of the gate structure 1013. A width of the dummy gate structure 1020 may be determined depending on a level of capacitance required for each of the ESD protective circuits 1000 and 1000A, and accordingly, a width of the dummy gate structure 1020 may be equal to or smaller than a width of the gate structure 1013 in example embodiments.

An ESD protective circuit according to one or more embodiments may include a switch element, a resistor element, and a capacitor provided by a gate structure, a first active region, and a second active region. A node between the resistor element and the capacitor may be electrically connected to a gate structure of the switch element, and the first active region and the second active region may be connected to a first power wiring pattern supplying a first power voltage and a second power wiring pattern supplying a second power voltage greater than the first power voltage, respectively. When ESD current is applied, a voltage applied to the gate structure may increase by the RC trigger operation, such that the ESD current may flow into a channel between the first active region and the second active region of the switch element.

In one or more embodiments, a capacitor may be implemented by an impurity region and a dummy gate structure formed on a substrate. The impurity region providing the capacitor may be formed by injecting impurities into a well region disposed to surround a switch element in a twin-well structure. Alternatively, in one or more embodiments, the impurity region providing the capacitor may be a portion of the first active region or the second active region providing the switch element. In example embodiments, two or more dummy gate structures may be provided, and the first dummy gate structure may be disposed in a portion of the impurity region formed in the well region disposed to surround the switch element, or the second dummy gate structure may be disposed in a portion of the first active region or the second active region.

As described above, instead of forming a separate MOS capacitor, by forming a dummy gate structure on a portion of the impurity region formed in the substrate for implementing a capacitor for RC trigger operation, integration density of the ESD protective circuit may be improved. A width and/or a length of the dummy gate structure may vary depending on capacitance required for performance of the ESD protective circuit.

According to one or more embodiments, instead of implementing a capacitor included in the ESD protective circuit as a MOS capacitor using a separate transistor, the capacitor may be implemented as a dummy gate structure formed on the active region included in the ESD protective circuit. Accordingly, a transistor to implement a capacitor occupying a large area may not be provided in the ESD protective circuit, and integration density of the ESD protective circuit and the semiconductor device including the same may be improved.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A semiconductor device, comprising:
a first well region (405; 605) in a substrate and doped with impurities of a first conductivity type;
a second well region (406; 606) in the substrate and doped with impurities of a second conductivity type, wherein the second well region (406; 606) is on internal sides of the first well region (405; 605) in a first direction that is parallel to an upper surface of the substrate;
a first impurity region (408; 608) in the first well region (405; 605) and doped with impurities of the first conductivity type;
a plurality of active regions (411, 412; 611, 612) in the second well region (406; 606) along the first direction and doped with impurities of the first conductivity type;
a gate structure (413; 613) between the plurality of active regions (411, 412; 611, 612) in the first direction;
a first dummy gate structure (420; 621) on the first impurity region (408; 608) and at least partially surrounding the second well region (406; 606); and
a plurality of wiring patterns (440; 640),
wherein the first dummy gate structure (420; 621) is connected to the gate structure (413; 613) by at least one wiring pattern of the plurality of wiring patterns (440; 640).

2. The semiconductor device of claim 1, wherein the plurality of wiring patterns (440; 640) comprise a first power wiring pattern (441; 641) configured to supply a first power voltage and a second power wiring pattern (442; 642) configured to supply a second power voltage greater than the first power voltage,
wherein the plurality of active regions (411, 412; 611, 612) comprise a first active region (411; 611) and second active region (412, 612),
wherein the first active region (411; 611) is connected to the first power wiring pattern (441; 641), and
wherein the second active region (412, 612) is connected to the second power wiring pattern (442; 642).

3. The semiconductor device of claim 2, further comprising:
a first contact connected to the first impurity region (408; 608) and connected to the first active region (411; 611).

4. The semiconductor device of claim 3, wherein the first contact is between the first dummy gate structure (420; 621) and the second well region (406; 606) in the first direction.

5. The semiconductor device of claim 3, wherein the first dummy gate structure (420; 621) is between the first contact and the second well region in the first direction.

6. The semiconductor device of any one of claims 2 to 5, further comprising:
a resistor element (R) connecting the first dummy gate structure (420; 621) and the gate structure (413; 613) to the second active region (408; 608).

7. The semiconductor device of any one of claims 2 to 6, further comprising:
a second impurity region (409; 609) in the second well region (406; 606) and doped with impurities of the second conductivity type having a concentration higher than a concentration of the impurities of the second conductivity type of the second well region (406; 606),
wherein the second impurity region (409; 609) is connected to the first active region (411; 611).

8. The semiconductor device of any one of claims 1 to 7, wherein, in the first direction, a width of the first dummy gate structure (420; 621) is greater than a width of the gate structure (413; 613).

9. The semiconductor device of any one of claims 1 to 8, further comprising:
an epitaxial layer (403; 603) in the substrate, below the first well region (405; 605) and below the second well region (406; 606).

10. The semiconductor device of any one of claims 1 to 9, wherein the semiconductor device further comprises a second dummy gate structure (622) on at least one of the plurality of active regions (611, 612) and connected to the first dummy gate structure (621).

11. The semiconductor device of any one of claims 1 to 10,
wherein the first impurity region (408; 608) and the first dummy gate structure (420; 621) have a shape surrounding the second well region (406; 606).

12. The semiconductor device of any one of claims 1 to 11,
wherein the first dummy gate structure (420; 621) and the first impurity region (408) provide a capacitor.

13. The semiconductor device of any one of claims 1 to 12,
wherein the plurality of active regions (411, 412; 611, 612) and the gate structure (413; 613) provide an NMOS transistor.

14. The semiconductor device of any one of claims 1 to 13,
wherein the plurality of active regions (411, 412; 611, 612) include a first active region (411; 611) and a second active region (412; 612), and
wherein an area of the first active region (411; 611) is smaller than an area of the second active region (412; 612).

15. The semiconductor device of claim 14,
wherein the first impurity region (408) is electrically connected to the second active region (412; 612) by at least one of the plurality of wiring patterns (440; 640).
